(19) Europäisches Patentamt
European Patent Office
Office européen des brevets

(11) **EP 4 382 945 A1**

(12) **EUROPEAN PATENT APPLICATION**

(43) Date of publication:
**12.06.2024 Bulletin 2024/24**

(21) Application number: **22212192.3**

(22) Date of filing: **08.12.2022**

(51) International Patent Classification (IPC):
**G01R 33/28** (2006.01)   **G01R 33/341** (2006.01)
**G01R 33/565** (2006.01)   **G01R 33/563** (2006.01)
**G01R 33/44** (2006.01)   **G01R 33/3415** (2006.01)

(52) Cooperative Patent Classification (CPC):
**G01R 33/341; G01R 33/286; G01R 33/56308;**
**G01R 33/56509;** G01R 33/3415; G01R 33/443

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**KH MA MD TN**

(71) Applicant: **Koninklijke Philips N.V.**
**5656 AG Eindhoven (NL)**

(72) Inventors:
• **RAHMER, Juergen Erwin**
  **Eindhoven (NL)**
• **GLEICH, Bernhard**
  **Eindhoven (NL)**
• **NIELSEN, Tim**
  **5656AG Eindhoven (NL)**
• **KOKEN, Peter**
  **5656AG Eindhoven (NL)**

(74) Representative: **Philips Intellectual Property &**
**Standards**
**High Tech Campus 52**
**5656 AG Eindhoven (NL)**

(54) **MAGNETIC RESONANCE IMAGING SYSTEM**

(57)     The invention relates to a magnetic resonance imaging (MRI) system 1 comprising a magnet unit 4 that carries out an MRI sequence for generating MRI signals of a patient 2, excites a resonator device 8, 38 attached to the patient or to an object not being the patient and comprising a resonator element having piezoelectric properties and a coil element connected to the resonator element, and receives resonator device signals from the resonator device. A processor 5 reconstructs an MR image of the patient based on the MRI signals and determines a property of the patient or the object, to which the resonator device is attached, based on the received resonator device signals. This allows determining the property of the patient or the object by the MRI system without necessarily requiring, besides the resonator device, additional hardware, i.e. the property can be determined without requiring sophisticated additional hardware.

Fig. 1

**Description**

FIELD OF THE INVENTION

The invention relates to a magnetic resonance imaging (MRI) system and method. The invention also relates to a computer program for controlling the MRI system. Moreover, the invention relates to a resonator device configured to be used with the MRI system and a processor, method and computer program for determining a property of a patient or an object within the MRI system.

BACKGROUND OF THE INVENTION

Due to the rather slow MRI data acquisition, generally MRI is very susceptible to patient motion, which can lead to image artifacts that compromise the diagnostic value. Different motion compensation approaches exist, wherein, for instance, image-based compensation often requires elaborate modification of MRI sequences, while motion measurements that are independent of MRI require the effort of operating additional hardware in the MRI environment, such as the pilot tone generators disclosed US 10,393,845 B2. Also, fast tracking of interventional devices in the MRI system usually involves additional wired marker coils and further sophisticated hardware as disclosed, for instance, in the article "MR-guided endovascular interventions: a comprehensive review on techniques and applications" by S. Kos et al., European Radiology, volume 18, number 4, pages 645 to 657 (2008). Not only the determination of the position or motion of the patient or another object like an interventional device in an MRI environment generally requires the use of sophisticated additional hardware, but also if other properties of the patient or the object like a physiological parameter should be determined in the MRI environment such hardware is required.

SUMMARY OF THE INVENTION

It is an object of the present invention to provide an MRI system and method that allow to determine a property of a patient or an object like the respective position with less sophisticated additional hardware. It is a further object of the present invention to provide a computer program for controlling the MRI system. Moreover, it is an object of the present invention to provide a processor, a method and a computer program for determining the property of the patient or the object in the MRI system. It is a further object of the present invention to provide a resonator device configured for allowing the processor to determine the property of the patient or the object in the MRI system.

In a first aspect of the invention an MRI system is presented, wherein the MRI system comprises:

- a magnet unit configured to carry out an MRI sequence for generating MRI signals of a patient, wherein the magnet unit is further configured to excite a resonator device, which is attached to the patient or to an object not being the patient and which comprises a resonator element having piezoelectric properties and a coil element connected to the resonator element, and to receive resonator device signals from the resonator device, and
- a processor that is configured to reconstruct an MR image of the patient based on the MRI signals and to determine a property of the patient or the object, to which the resonator device is attached, based on the received resonator device signals.

Since the magnet unit of the MRI system, which is used already for generating the MRI signals, is also used for exciting the resonator device, wherein in response to this excitation the resonator device generates resonator device signals that are used by the processor for determining the property of the patient or the object, the property of the patient or the object can be determined in the MRI environment, particularly during an actual MR imaging procedure, without necessarily requiring, besides the resonator device, additional hardware. The property of the patient or the object therefore can be determined in the MRI environment without requiring sophisticated additional hardware.

The magnet unit of the MRI system comprises the coils required for carrying out an MR imaging procedure. In particular, it includes coils for generating the static magnetic field, for generating gradient fields, for transmitting radio frequency (RF) signals and for receiving RF signals. Additional coils are not necessarily required for exciting the resonator device that produces the resonator device signals that are used by the processor for determining the property of the patient or the object, to which the resonator device is attached. The magnet unit also comprises equipment for operating the coils like a power source and a controller for controlling the coils and preferentially also for processing the received signals as known in the art. The magnet unit preferentially is configured to excite the resonator device by using a resonator device excitation pulse. In an example the frequency of the resonator device excitation pulse is centered on the resonance frequency of the resonator device.

The object preferentially is an interventional device to be used during an interventional procedure.

In an example, the processor is configured to determine the position of the resonator device based on the received resonator device signals and to determine, as the property of the patient or the object, to which the resonator device is attached, the position of the patient or the object, respectively, based on the determined position of the resonator device. In particular, the processor can be configured to determine the position of the patient or the object over time and to determine patient motion or object motion, respectively, based on the determined position of the resonator device over time. For instance, the processor can be configured to determine cardiac motion and/or respiratory motion over time as the patient motion. It is also possible that the processor is configured to determine another kind of motion like patient motion not being cardiac motion and not being respiratory motion. For example, one or several resonator devices can be placed directly on the patient, for instance, on the skin of the chest to detect breathing and heartbeat, or on the head to track involuntary motion in, for example, brain scans. Thus, the position, in particular the position over time and hence the motion, of the patient or the object can be determined in an MRI environment with relatively low hardware requirements, i.e. it is possible to use the magnet unit of the MRI system, which is there already and used for the MR imaging procedure, also for generating the resonator device signal, without necessarily requiring additional hardware.

If the object is an interventional device for carrying out an interventional procedure on the patient, the processor can be configured to determine the position of the resonator device and to determine the position of the interventional device based on the determined position of the resonator device. In particular, the processor can be configured to determine the position over time, in order to track the interventional device over time. Thus, it is also possible to track an interventional device in the MRI system, without necessarily requiring, for instance, additional wired marker coils and hardware, i.e. preferentially only a wireless passive resonator device is required as additional hardware for providing the tracking functionality.

In an example, the magnet unit comprises several receive coils that are configured to receive MRI signals and that are also used for receiving several resonator device signals from the resonator device, i.e. a respective receive coil receives a respective resonator device signal. The receive coils have known coil sensitivity profiles, wherein in this embodiment the processor is configured to determine the position of the resonator device based on the amplitudes of the received resonator device signals and the known coil sensitivity profiles and to determine as the property of the patient or the object, to which the resonator device is attached, the position of the patient or the object, respectively, based on the determined position of the resonator device. Thus, a resonator device can be attached to the patient or to an object to be tracked and the position of the resonator device and thereby of the patient or the object, respectively, can be determined, in an embodiment, by pure sensitivity encoding based on the amplitude distribution observed in the coils, which might be regarded as a coil array, with known coil sensitivity profiles. In particular, the position of the resonator device can be determined, without necessarily requiring a gradient-based spatial encoding. The acquisition window, i.e. the time in which the resonator device signal is received, therefore can be very short. This allows for a high temporal resolution.

In an example, the resonator device is attached to the patient, wherein the processor is configured to determine the position of the patient over time, to determine patient motion based on the determined position of the patient over time, and to reconstruct a motion corrected MR image of the patient based on the generated MRI signal and the determined patient motion. For determining the motion corrected MR image based on the MRI signal and the patient motion, known MR image reconstruction and motion correction algorithms can be used. For instance, the processor can be configured to adapt a provided temporally modifiable patient model to the determined patient motion such that the patient model moves over time in accordance with the determined motion and to use the adapted patient model for generating the motion corrected MR image of the patient.

As also explained above, due to the rather slow MRI data acquisition, generally MRI is very susceptible to patient motion, which can lead to image artifacts that compromise the diagnostic value. Different motion compensation approaches exist, wherein, for instance, image-based compensation often requires elaborate modification of MRI sequences, while motion measurements that are independent of MRI require the effort of operating additional hardware in the MRI environment. By using the resonator device as described above, it is possible to provide motion corrected MR images, without necessarily requiring elaborate modifications of MRI sequences and without necessarily requiring the effort of operating additional hardware in the MRI environment, except the resonator device. Thus, by using the property, which in this example is the position of the patient over time and hence patient motion and which has been determined with relatively low hardware requirements in the MRI environment, MR images can be reconstructed having an improved image quality.

In an example the resonator device is attached to the patient, wherein the processor is configured to determine the position of the patient over time, to determine patient motion based on the determined position of the patient over time, and to determine a patient motion related physiological parameter based on the determined patient motion. For instance, the processor can be configured to determine patient motion caused by the heart and/or by respiration and to determine the heart rate and/or the respiratory rate depending on the determined patient motion, respectively. Thus, by using the property, which in this example is the position of the patient over time and hence patient motion and which has been determined with relatively low hardware requirements in the MRI environment, physiological properties like the heart rate and/or the respiratory rate can be determined in an MRI system, without necessarily requiring, in addition to the resonator device, further hardware.

In an example, the magnet unit comprises coils configured to carry out the MRI sequence for generating the MRI signals of the patient, wherein at least one coil is regarded as being the object to which the resonator device is attached and wherein the processor is configured to determine the position of the at least one coil over time, to determine motion of the at least one coil based on the determined position of the at least one coil over time and to generate a coil motion corrected MR image of the patient based on the generated MRI signal and the determined motion of the at least one coil. In particular, the processor comprises sensitivity profiles of the coils and is configured to determine motion of the sensitivity profile of the at least one coil provided with the resonator device based on the determined motion of the coil and to generate the coil motion corrected MR image of the patient based on the generated MRI signal and the determined motion of the sensitivity profile. In known MR image reconstruction algorithms, the position of the sensitivity profiles of the coils is used, which has been determined in pre-scans and which is not updated during the actual MR imaging procedure. Therefore, inaccuracies related to coil motion can occur. By considering the actual positions of the coils during imaging, in particular by continuously tracking the coil positions, and by considering the correspondingly moving sensitivity profiles while reconstructing the MR images, the quality of the MR images can be increased, without necessarily requiring, besides the resonator device, additional hardware. For instance, the magnet unit can comprise at least one receive coil to be placed on the patient, wherein the motion of the receive coil can be tracked by using one or several resonator devices arranged on the receive coil and this tracking information can be used to update the information used in sensitivity encoded image reconstruction.

In an example the magnet unit is able to excite several resonator devices, which have different resonance frequencies and/or different quality factors and which are attached to at least one of the patient and the object, and to receive several resonator device signals, which have different frequencies that correspond to the different resonance frequencies of the several resonator devices and/or different attenuations corresponding to the different quality factors of the several resonator devices, from the several resonator devices, wherein the processor is configured to determine one or several properties of at least one of the patient and the object, to which the respective resonator device is attached, based on the received resonator device signals. Thus, the magnet unit can excite several resonator devices, each comprising a coil element and a resonator element that might also be named resonant element, and receive several resonator device signals from the several resonator devices and the processor can be configured to determine one or several properties of the object and/or patient based on the several received resonator device signals. The several resonator devices can all be arranged only on the patient or only on the object, or they can be arranged on both, i.e. the patient and the object. Moreover, no, one or several objects can be present, wherein one or several resonator devices can be arranged on the one or several objects. Correspondingly, the processor can be configured to determine a property of the patient only, a property of the one object or several objects only, if present, or a property of the patient and a property of the one or several objects, based on the resonator device signals.

For instance, the processor can be configured to determine the positions of the several resonator devices, wherein a respective position of a respective resonator device is determined based on the respective signal having the resonance frequency of the respective resonator device and/or having the attenuation corresponding to the quality factor of the respective resonator device, and to determine as the property of at least one of the patient and the object, to which the resonator device is attached, the position of at least one of the patient and the object, based on the respective determined position of the respective resonator device.

In particular, the motion of many resonator devices arranged on the patient and having different resonance frequencies and/or different quality factors can be determined in parallel, thereby defining, for instance, a four-dimensional motion field. The motion field can directly be used for generating the motion corrected MR image or it can be used for adapting a corresponding four-dimensional patient model, wherein then the four-dimensional patient model can be used for the generation of the motion corrected MR image. Thus, in an example many resonator devices can be operated in parallel, wherein their signals can be spectrally resolved and/or resolved based on their attenuation, in order expand the tracking concept to a four-dimensional field of motion vectors, to which, for instance, a patient model can be fitted to increase the accuracy of motion tracking. The motion information can then be fed back into the MR image reconstruction to remove motion artifacts.

In an example the magnet unit is configured to carry out the MRI sequence for generating the MRI signals of the patient in a predefined imaging frequency range of the MRI system and to excite the resonator device and to receive the resonator device signals from the resonator device with a frequency within the imaging frequency range. Hence, the resonator device can be tuned to a frequency in the imaging frequency range, which also might be regarded as being an MRI band, wherein the magnet unit can excite the resonator device within this imaging frequency range. Preferentially, the magnet unit is configured to excite the resonator device and to receive a resonator device signal from the resonator device with a frequency which differs from the MR frequency of at least one of water and fat. Thus, preferentially the excitation frequency for exciting the resonator device and hence the resonance frequency of the resonator device differs from the water and fat resonance frequencies observed from patient tissue to ensure that it does not interfere with MR imaging, but at the same time it is within the frequency band that the MRI receiver, i.e. the magnet unit of the MRI system, is surely able to detect. The property of the patient or the object, to which the resonator device is attached, therefore can be determined with even lower technical requirements, wherein still, beside the resonator device, no additional hardware is necessarily required.

Moreover, the magnet unit preferentially is configured to excite the resonator devices with resonance frequencies on one side of the MR frequency of protons. The imaging frequency range preferentially covers the resonance frequency of protons. If the resonator devices are excited by using frequencies only on one side of the proton MR frequency and not on both sides of the proton MR frequency, the resonator devices can be relatively easily excited, particularly simultaneously, still without necessarily requiring any additional hardware besides the resonator devices. Generally, the magnet unit can be configured such that all resonator devices are excited jointly, particularly using short pulses, or selectively, particularly using longer pulses. That is, according to this aspect of the invention, the magnetic resonance imaging system is configured to excite the resonator devices with resonance frequencies on one side of the magnetic resonance frequency of protons.

In an example the processor is configured to a) determine at least one of the amplitude and the phase of the received resonator device signals, b) determine a modulation of at least one of the amplitude and the phase by at least one of the patient and the object, and c) carry out at least one of i) determining modulation-corrected received resonator device signals based on the determined modulation and received resonator device signals and determining the property based on the modulation-corrected received resonator device signals and ii) determining the property directly based on the determined modulation. The processor preferentially is configured to determine the modulation based on the received resonator device signals. In particular, the processor is configured to provide a modulation model that models the modulation of at least one of the amplitude and the phase by the patient or object, to which the resonator device is attached, and adapt the modulation model based on at least one of the amplitude and the phase of the received resonator device signals, thereby determining the modulation. The processor can be configured to use the modulation for determining information on the patient anatomy, the patient position and/or patient motion as the property. Thus, the signals picked up by the magnet unit, in particular by a receive coil array of the magnet unit, can be modulated in amplitude and phase by the patient body, wherein this modulation can be used to extract information on, for instance, patient anatomy, positioning and/or motion. Or, for instance, if changes of the amplitude and/or the phase due to the patient body or the object occur, these may be corrected for when determining the property like the position from, for instance, the coil sensitivities, which might have been determined for vacuum, by using, for example, the modulation model. This can allow for an improved quality of the determined property, still without necessarily requiring additional hardware besides the one or several resonator devices. The modulation of the amplitude and phase might be caused by eddy currents and permeability effects.

In an example the magnet unit is configured to excite several resonator devices, which are arranged at different locations on the patient and which have different resonance frequencies and/or different quality factors, and to receive several resonator device signals, which have different frequencies that correspond to the different resonance frequencies of the several resonator devices and/or which have different attenuations that correspond to the different quality factors, from the several resonator devices, wherein the processor is configured to determine which resonator device signals originate from which location on the patient based on the different frequencies and/or the different attenuations, to determine an eddy current distribution within the patient based on the received resonator device signals and based on the locations from which the received resonator device signals originate and to determine the property of the patient based on the determined eddy current distribution. In particular, the processor can be configured to determine at least one of a magnetic induction tomography image and a pulse wave velocity in a pulmonary artery or the aorta of the patient as the property based on the determined eddy current distribution. Thus, the use of many resonator devices allows the derivation of an eddy current distribution from the amplitude and phase effect on the received resonator device signals, giving the information that can be used for magnetic induction tomography, wherein, based on the eddy current distribution, in addition or alternatively, the processor also can be able to extract, for instance, pulse wave velocities in pulmonary arteries or the aorta. For reconstructing the magnetic induction tomography image known reconstruction algorithms can be used like an algorithm disclosed in the article "Magnetic induction tomography" by H. Griffiths, Measurement Science and Technology, volume 12, issue 8, pages 1126 to 1131 (2001), which is herewith incorporated by reference.

The resonator device signal preferentially is an RF signal. Moreover, in an example the magnet unit is configured to excite the resonator device with an excitation pulse signal having a pulse duration being equal to or smaller than 20 $\mu$s. It has been found by the inventors that already such a short pulse duration can allow for a sufficiently accurate determination of the property like the position of the patient and/or of the object. Due to this shortness, the temporal resolution can be further increased. Moreover, the short excitation pulse also leads to a small flip angle of, for instance, about 1°. This small flip angle only results in a very low interference with protons, thereby only very slightly affecting MR imaging, even if MR imaging and property determination like position detection are carried out simultaneously and the resonance frequency of the resonator device would be close to the resonance frequency of protons, i.e. of hydrogen nuclei. However, in an example the pulse duration can also be longer. For instance, the magnet unit can be configured to excite the resonator device with an excitation pulse signal having a pulse duration being sufficiently long to not excite protons in the patient. Also this further increases the capability of determining the property like the position, without adversely influencing the MRI procedure.

The magnet unit can be configured to receive the resonator device signals and the MRI signals in parallel or in an interleaved way.

In another aspect of the present invention a resonator device is presented, wherein the resonator device is configured for allowing the processor to determine a property of a patient or an object in the MRI system, when the resonator device is attached to the patient or the object, respectively, wherein preferentially the resonator device is a passive resonator device, comprises a resonator element having piezoelectric properties and a coil element connected to the resonator element and is configured to generate a resonator device signal when the resonator device is excited by a magnet unit of the MRI system.

The resonator device preferentially is regarded as being passive, if it does not have a long term energy storage or energy source. In an embodiment, the term "long term" is defined as $10^7$ times the time of one period of the oscillation frequency of the resonator device or longer. For instance, if the magnet unit of the MRI system generates a static magnetic field of 1.5 T, the oscillation frequency might be about 64 MHz and hence the time of one period might be about 15 ns. Thus, in this example the term "long term" refers to 0.15 s or longer. This time might also be understood as the half life time of the stored energy, i.e. the time at which the storage has lost half of the initial energy.

Preferentially, the resonator device is wireless, i.e., for instance, it has no wired connection to an external energy source.

In an example the coil element is a loop coil. Moreover, in an example the resonator element is a crystal resonator element like a quartz resonator element. The resonance frequency of the resonator element and hence of the resonator device comprising the resonator element and the loop coil can be, for instance, 64 MHz.

In an example the coil element is configured to transduce an external magnetic or electromagnetic excitation field into an output voltage to be provided to the resonator element and the resonator element is configured to transduce the output voltage into respective mechanical oscillations in a resonant mode and to provide a piezoelectric voltage to the coil element, wherein the coil element is configured to transduce the piezoelectric voltage into the resonator device signal to be received by the magnet unit of the MRI system. Thus, the resonator device combines a magnetic coil resonator, in terms of the coil element, with an energy-storing oscillator, in terms of the resonator element having piezoelectric properties. More particularly, the magnet unit of the MRI system externally applies a magnetic or electromagnetic excitation field to cause mechanical oscillations at the resonance frequency of the resonator element. Hereby, the oscillation is persistent due to the high quality factor of the circuit.

In particular, as also explained above, already a short pulse duration of, for instance, 20 μs can allow for a sufficiently accurate determination of the property like the position of the patient and/or the object. Hence, the resonator device can be excited using a relatively short low-energy RF pulse, which is picked up by its antenna, i.e. its coil element, and starts a resonant mechanical oscillation in the resonator element, particularly the crystal, that stores energy. After excitation, the crystal feeds back its energy to the coil element, i.e. the antenna, generating a signal response of preferentially at least several hundred micro-seconds, that can be received by the magnet unit. Thus, once excited, the resonator device can act as a local transmitter.

In an example the resonator device has a quality factor being equal to or larger than 100. It is preferred that the quality factor is equal to or larger than 1000 and it is further preferred that the quality factor is equal to or larger than 10000.

Moreover, preferentially, the resonator device further comprises a capacitive element such as a capacitor. The capacitive element may particularly be added to the resonator device such as to be connected in parallel to the coil element. That is, in a resonator device comprising a capacitive element, the coil element and the resonator element may be connected in series and the capacitive element may be connected in parallel to the coil element. This essentially provides a resonator circuit which has an LC resonator and a piezoelectric resonator combined with one another.

The capacitive element may particularly be chosen to have a capacitance that amplifies the output voltage provided by the coil element in response to the externally applied magnetic or electromagnetic excitation field. This higher output voltage may then be provided to the resonator element, causing stronger deformations therein and, hence, a higher level of oscillation in the resonator element having piezoelectric properties for a given set of field parameters such as amplitude, frequency and duration. This, in turn, results in a higher piezoelectric voltage acting upon the coil element, meaning that the signal strength may be improved. The value of the capacitance of the capacitive element may be chosen such that the resonance frequency of the coil element in the LC resonator corresponds to the resonance frequency of the resonator element, i.e. the piezoelectric resonator. This allows to reduce the amount of windings needed, as the loss during oscillation of the resonator circuit becomes low. With less windings, the manufacture of the marker device is simplified.

In an example the coil element includes a coil wound around the resonator element or printed on an outer surface of the resonator element. This allows to reduce the size of the resonator device, wherein still the property of the patient or the object, to which the resonator device is attached, can be determined, without necessarily requiring, besides the resonator device, additional hardware.

The coil element and the resonator element are electrically connected to one another, wherein the coil element may particularly comprise or be made of a copper. In some embodiments, the coil element may, alternatively or additionally, comprise or be made of silver or comprise or be made of another metal. Further, the term resonator element may, in this context, be understood as corresponding to an element that is connected to the coil element in order to respond to the coil element's voltage output in response to an externally applied magnetic or electromagnetic field by respectively deforming and, thus, starting to perform mechanical oscillations. As mentioned above, the resonator element may particularly comprise a crystal such as a quartz crystal, but it is also possible that the resonator element comprises another material such as ceramics or the like.

The mechanical oscillations of the resonator device shall particularly be provided in resonant mode. This is to be understood as meaning that the resonator device shall, in response to the output voltage applied to it, start oscillating at or near to its resonance frequency. In an example this is achieved by having the magnetic or electromagnetic field externally applied by the magnet unit provided with the right frequency components to lead to an output voltage of the coil element that achieves such resonant mechanical oscillations. Due to the resonator element oscillating at its resonance frequency, it acts as an energy storage even in cases where no output voltage is applied anymore. This reduces the damping of the resonant circuit formed by the coil element and the resonator element and hence can lead to the high quality factor mentioned above.

The term piezoelectric properties shall be understood within the conventional meaning, i.e. as describing a material which deforms in response to an electrical voltage being applied thereto and which, in response to the mechanical stress exerted by the deformation, accumulates electric charge that may be output in terms of a piezoelectric voltage. The accumulation of electric charge may hereby happen in a reversible manner, i.e. changes in mechanical stress from a first state to a second state may lead to the electric charge being accumulated and changes from the second state to the first state in mechanical stress will result in the material having the same (electric) properties as before again.

The term coil element may particularly refer to an element comprising and/or corresponding to a magnetic coil arrangement having a particular number of windings. In some embodiments, the coil element may be an off-the-shelf magnetic coil having an appropriate amount of windings, an appropriate size and an appropriate distance between the windings. The amount and size of and distance between the windings may hereby particularly be determined on the basis of the desired magnetic properties of the coil element. In an example, where space needs to be saved, the resonator element may be provided inside the coil element and may be electrically connected to contacts of the coil element. Alternatively, the resonator element may be provided at some distance away from the coil element while still being electrically connected thereto via a respective connection portion including, for instance, electrical contacts. In an example the coil element may particularly be provided by winding a coil around the resonator element, whereby the coil is wound in a manner such that it does not touch the resonator element, i.e. such that there is a space between the windings of the coil element and the resonator element. The dimensions of this space should hereby be chosen appropriately according to the dimensioning of the resonator device. Hereby, it should be noted that the windings of the coil element become more efficient when they are further away from a rotational axis of the coil element. The arrangement between the resonator element and the coil element may therefore be such that the resonator element may be provided in the coil element and extends along its axis. For more details regarding the resonator device reference is made to WO 2022/129310 A1 which is herewith incorporated by reference.

In a further aspect of the present invention a processor for determining a property of a patient or an object in the MRI system is presented, wherein a resonator device is attached to the patient or the object, wherein the processor is configured to determine the property based on a received resonator device signals, wherein the resonator device signals have been received from the resonator device by a magnet unit of the MRI, after the magnet unit has excited the resonator device, wherein the resonator device comprises a resonator element having piezoelectric properties and a coil element connected to the resonator element.

In a further aspect of the present invention an MRI method is presented, wherein the MRI method comprises:

- carrying out an MRI sequence for generating MRI signals of a patient by a magnet unit, wherein the magnet unit further excites a resonator device, which is attached to the patient or to an object not being the patient and which comprises a resonator element having piezoelectric properties and a coil element connected to the resonator element, and receives resonator device signals from the resonator device, and
- reconstructing an MR image of the patient based on the MRI signals and determining a property of the patient or the object, to which the resonator device is attached, based on the received resonator device signals by a processor.

In a further aspect of the present invention a method for determining a property of a patient or an object in the MRI system is presented, wherein a resonator device is attached to the patient or the object, the method comprising determining the property based on received resonator device signals, wherein the resonator device signals have been received from the resonator device by a magnet unit of the MRI system, after the magnet unit has excited the resonator device, wherein the resonator device comprises a resonator element having piezoelectric properties and a coil element connected to the resonator element.

In a further aspect of the present invention a computer program for controlling the MRI system is presented, the computer program comprising program code means for causing the MRI system to carry out the steps of the MRI method, when the computer program is run on a computer controlling the MRI system.

In a further aspect of the present invention a computer program for determining a property of a patient or an object in the MRI system is presented, wherein a resonator device is attached to the patient or the object, wherein the computer program is configured to, when the computer program is run on a computer, determine the property based on received resonator device signals, wherein the resonator device signals have been received from the resonator device by a magnet unit of the MRI system, after the magnet unit has excited the resonator device, wherein the resonator device comprises a resonator element having piezoelectric properties and a coil element connected to the resonator element.

It shall be understood that the MRI system of claim 1, the processor of claim 12, the resonator device of claim 13, the methods of claims 14 and 15 and the computer programs of claims 16 and 17 have similar and/or identical preferred embodiments, in particular, as defined in the dependent claims.

It shall be understood that a preferred embodiment of the present invention can also be any combination of the dependent claims or above embodiments with the respective independent claim.

These and other aspects of the invention will be apparent from and elucidated with reference to the embodiments described hereinafter.

BRIEF DESCRIPTION OF THE DRAWINGS

In the following drawings:

Fig. 1 shows schematically and exemplarily an embodiment of an MRI system,
Fig. 2 shows schematically and exemplarily an embodiment of a resonator device to be used in the MRI system,
Fig. 3 shows schematically and exemplarily an embodiment of an interventional device, to which a resonator device is attached, to be used in the MRI system,
Fig. 4 shows schematically and exemplarily a further embodiment of a resonator device to be used in the MRI system,
Fig. 5 shows schematically and exemplarily an equivalent circuit for the embodiments of the resonator devices,
Fig. 6 shows a flowchart schematically illustrating an embodiment of an MRI method,
Fig. 7 shows schematically and exemplarily MRI signals and resonator device signals for a single readout,
Fig. 8 shows schematically and exemplarily resonator device signals and MRI signals for several readouts,
Fig. 9 shows schematically and exemplarily changes of amplitudes of resonator device signals caused by motion, and
Fig. 10 shows schematically and exemplarily a determined position of a resonator device signal over time, which has been determined based on the resonator device signals shown in Fig. 9

DETAILED DESCRIPTION OF EMBODIMENTS

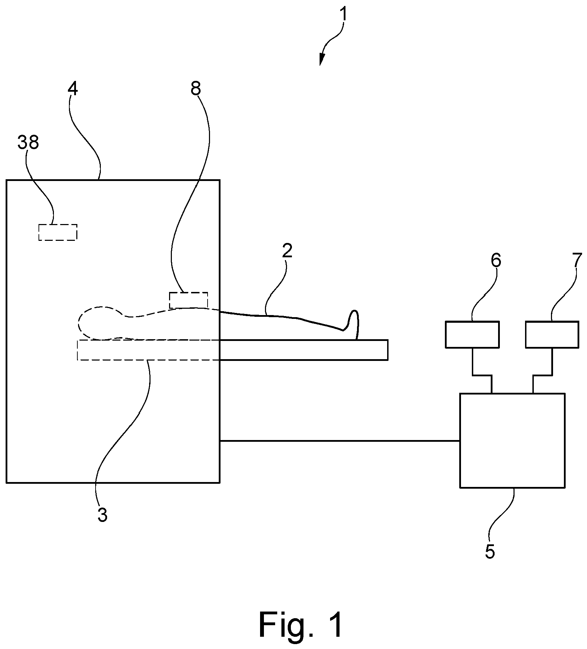

Fig. 1 shows schematically and exemplarily an embodiment of an MRI system. The MRI system 1 comprises a magnet unit 4 configured to carry out an MRI sequence for generating MRI signals of a patient 2 arranged on a patient table 3. The magnet unit 4 comprises the well-known coils of an MRI system like a coil for generating the static magnetic field, gradient coils, receive coils and transmit coils and optionally also shim coils. It is also possible that the same coils are used as transmit and receive coils. The magnet unit 4 further comprises a power supply and a controller for operating the coils of the magnet unit. These different components of the magnet unit, which are well-known, are not shown in Fig. 1 for clarity reasons.

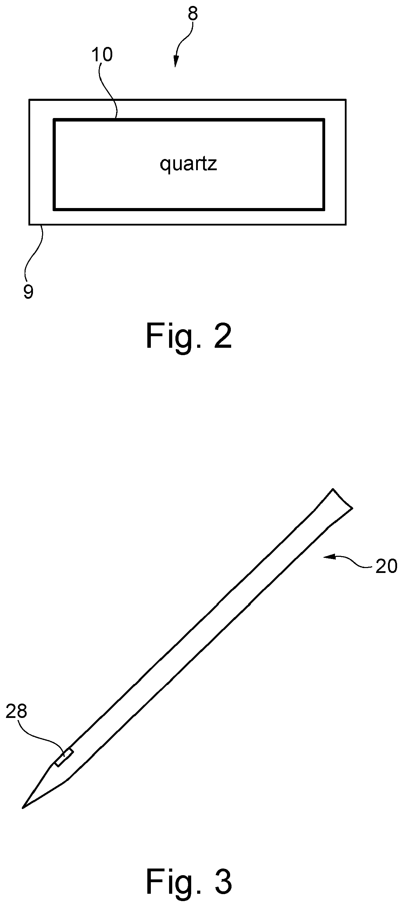

The magnet unit 4 is also configured to excite a resonator device 8, which is attached to the patient 2. In this example, the resonator device 8 is attached to the chest of the patient 2. The resonator device 8 comprises a resonator element 9 having piezoelectric properties and a coil element 10 connected to the resonator element 9, for instance as schematically and exemplarily illustrated in Fig. 2. In the example illustrated in Fig. 2, the coil element 10 is a loop coil printed on an outer surface of the resonator element 9. The resonator device 8 is a passive resonator device and wireless. Moreover, in this example the resonator element 9 is a quartz crystal.

The coil element 10 is configured to transduce an external magnetic or electromagnetic excitation field into an output voltage to be provided to the resonator element 9 and the resonator element 9 is configured to transduce the output voltage into respective mechanical oscillations in a resonant mode and to provide a piezoelectric voltage to the coil element 10. The coil element 10 is configured to transduce the piezoelectric voltage into a resonator device signal to be received by the magnet unit 4 of the MRI system 1.

The MRI system 1 further comprises a processor 5 that is configured to reconstruct an MR image of the patient

2 based on the MRI signals and to determine a property of the patient 2, to which the resonator device 8 is attached, based on received resonator device signals.

In an example the processor 5 is configured to determine the position of the resonator device 8 based on the received resonator device signal and to determine, as the property of the patient 2, to which the resonator device 8 is attached, the position of the patient 2 based on the determined position of the resonator device 8. In particular, the processor 5 can be configured to determine the position of the patient 2 over time and to determine patient motion based on the determined position of the resonator device 8 over time. For instance, the processor 5 can be configured to determine cardiac motion and/or respiratory motion over time as the patient motion. It is also possible that the processor 5 is configured to determine another kind of motion like patient motion not being cardiac motion and not being respiratory motion. For example, one or several of the resonator devices 5 can be placed directly on the patient 2, for instance, on the skin of the chest as schematically and exemplarily illustrated in Fig. 1, to detect breathing and heartbeat, or on the head of the patient 2 to track involuntary motion in, for example, MRI brain scans.

The processor 5 can be configured to determine the type of motion by spectral analysis. For instance, the processor 5 can determine whether the patient motion is within a predefined cardiac frequency range or within a predefined respiratory frequency range, wherein, if the frequency of the currently determined patient motion is within a respective one of these predefined frequency ranges, the processor 5 can determine that the determined motion is cardiac motion or respiratory motion, respectively. The patient motion also can include contributions from different types of motion, wherein the processor 5 can be configured to determine the different kinds of motion also based on a frequency analysis. For instance, the determined motion over time can be Fourier transformed, in order to determine frequency components in the predefined cardiac and respiratory frequency ranges, wherein a frequency component within the predefined cardiac frequency range indicates cardiac motion having the frequency of the frequency component and a further frequency component within the predefined respiratory frequency range indicates respiratory motion with the frequency of this frequency component.

In an example the magnet unit 4 comprises several receive coils that are configured to receive MRI signals and that are also used for receiving several resonator device signals from the resonator device 8, i.e. a respective receive coil of the magnet unit 4 receives a respective resonator device signal from the resonator device 8. The receive coils have coil sensitivity profiles which are different and which are known by the processor 5. The processor 5 can be configured to determine the position of the resonator device 8 based on the amplitudes of the received resonator device signals and the known coil sensitivity profiles. In this regard, the processor 5 can be configured to use, for instance, the technique disclosed in US 5,752,513, which is herewith incorporated by reference, or another known technique.

The processor 5 can also be configured to use the determined patient motion for the reconstruction of the MR image. In particular, the processor 5 can be configured to reconstruct a motion corrected MR image of the patient 2 based on the generated MRI signal and the determined patient motion. For instance, the processor 5 can be configured to adapt a provided temporally modifiable patient model to the determined patient motion such that the patient model moves over time in accordance with the determined patient motion and to use the adapted patient model for generating the motion corrected MR image of the patient 2. In this regard, the processor 5 can be configured to use, for instance, the technique disclosed in the article "Motion correction in MRI of the brain" by F. Godenschweger et al., Journal of Physics in Medicine and Biology, R61(5): R32-56 (2016), which is herewith incorporated by reference, or another known technique.

Moreover, the processor 5 can be configured to a) determine at least one of the amplitude and the phase of the received resonator device signals, b) determine a modulation of at least one of the amplitude and the phase by the patient 2 and c) carry out at least one of i) determining modulation-corrected received resonator device signals based on the determined modulation and received resonator device signals and determining the property based on the modulation-corrected received resonator device signals and ii) determining the property directly based on the determined modulation. Thus, for instance, if changes of the amplitude and/or the phase of the received resonator device signals occur due to the patient body, these changes can be corrected for by the processor 5 when determining the property like the patient position. The changes, or in other words the modulation, of the amplitude and phase of the received resonator device signals due to the patient's body might be caused by eddy currents and permeability effects.

The processor 5 can be configured to determine the modulation based on the received resonator device signals. In particular, the processor 5 can be configured to provide a modulation model that models the modulation of at least one of the amplitude and the phase by the patient's body and to adapt the modulation model based on at least one of the amplitude and the phase of the received resonator device signals, wherein the adapted modulation model defines the modulation to be determined.

The processor can also be configured to use the modulation for determining information on the patient anatomy, the patient position and/or patient motion as the property. Thus, the signals picked up by the magnet unit 4, in particular by a receive coil array of the magnet unit 4, can be modulated in amplitude and phase by the patient's body, wherein this modulation can be used to determine a patient's property, i.e. to extract information on, for instance, patient anatomy, patient positioning and/or patient motion. In an example, following equation might be fitted to the received resonator device signals:

$$S = A \sin(\omega t + \varphi)\, e^{-\frac{t}{\tau}} \qquad , \qquad\qquad (1)$$

wherein S denotes the received resonator device signal, $A$ denotes the amplitude, $\omega$ denotes the frequency, $t$ denotes the time, $\varphi$ denotes the phase and $\tau$ denotes the time constant.

During the fitting procedure, preferentially the frequency $\omega$ and the time constant $\tau$ remain constant and the amplitude $A$ and the phase $\varphi$ are fitted for each pulse of the received resonator device signal individually. Thus, for each pulse of the received resonator device signal a respective amplitude $A$ and a respective phase $\varphi$ are determined, i.e. the amplitude $A$ and the phase $\varphi$ can change from pulse to pulse and therefore overtime. This change of the amplitude $A$ and the phase $\varphi$ is regarded as being the modulation in this example. In particular, if the amplitude $A$ and the phase $\varphi$ change over time, it can be determined that the patient's body has moved. If the change of the amplitude A and the phase $\varphi$ over time is in a respiratory frequency range, the processor 5 can determine that the movement is respiratory motion. For instance, if the frequency of the modulation of the amplitude $A$ and the phase $\varphi$ is at around 0.1 Hz, the processor 5 can determine that the modulation in the received resonator device signals due to the patient's body is caused by respiration and hence the processor 5 can determine, for example, the respiration rate as a property of the patient based on the modulation of the received resonator device signals due to the patient's body. If the modulation of the amplitude $A$ and the phase $\varphi$ is in a cardiac frequency range, the processor 5 can determine that the modulation of the received resonator device signals by the patient's body is due to cardiac motion. In this case, for instance, the processor 5 can determine the heart rate of the patient based on the received resonator device signals, i.e. based on the modulation of the received resonator device signals due to cardiac motion of the patient's body. For example, if the frequency of the modulation of the amplitude $A$ and the phase $\varphi$ is around 1 Hz, the processor 5 can determine that the frequency of the modulation of the received resonator device signals is caused by cardiac motion of the patient's body and hence determine that the frequency of the modulation of the amplitude $A$ and the phase $\varphi$ is the heart rate. In this example, it is assumed that the magnet unit, in particular one or several send coils and one or several receive coils or at least one combined send and receive coil of the magnet unit, is fixed, i.e. do not move. Moreover, in this example, many excitation and readout cycles are carried out, wherein each cycle is carried out in the same way, in order to ensure that changes in the amplitude $A$ and in the phase $\varphi$ are not caused by different excitation and readout cycles. Each excitation and readout cycle uses an excitation pulse and reads a corresponding receive pulse being the respective pulse of the received resonator device signals.

For determining the patient anatomy and/or the patient position based on the modulation of the received resonator device signals due to the patient's body, an eddy current distribution within the patient's body can be determined, which can directly be used for determining the patient anatomy and/or the patient position, i.e. the eddy current distribution can directly provide this information. It is also possible that the processor calculates a conductivity distribution based on the eddy current distribution and that then the conductivity distribution indicates the patient anatomy and/or the patient position. Furthermore, the processor can be configured to calculate a magnetic induction tomography image based on the modulation of the received resonator device signals by the patient's body, wherein the magnetic induction tomography image shows the patient anatomy and the patient position. The determination of the magnetic induction tomography image will be described in more detail further below.

In an example, the processor is configured to use a machine learning algorithm for determining the patient anatomy and/or the patient position based on the modulation of the received resonator device signals. In particular, the machine learning algorithm can be trained by using training data sets which comprise received resonator device signals, which have been received while the patient anatomy and the patient position were known, wherein the machine learning algorithm is trained such that, given the received resonator device signals of the training data sets, it outputs the known patient anatomies and patient positions of the training data sets. In a preferred embodiment, the machine learning algorithm uses a neural network being a deep learning network and/or a convolutional neural network.

If several of the resonator devices 8 are arranged at different locations on the patient 2, wherein the several resonator devices 8 have different resonance frequencies and/or different quality factors, the magnet unit 4 can excite the several resonator devices. Moreover, the magnet unit 4 can then also be configured to receive several resonator device signals, which have different frequencies that correspond to the different resonance frequencies of the several resonator devices and/or which have different attenuations that correspond to the different quality factors of the several resonator devices. The processor 5 can then be configured to determine which resonator device signals originate from which location on the patient 2 based on the different frequencies and/or the different attenuations, to determine an eddy current distribution within the patient 2 based on the received resonator device signals and based on the locations from which the received resonator device signals originate and to determine the property of the patient 2 based on the determined eddy current distribution.

Thus, in an embodiment the several resonator devices can have a same resonance frequency, but different quality factors, wherein the processor 5 can determine which resonator device signals originate from which resonator device based on the attenuation of the amplitude of the respective resonator device signals. In particular, due to the different quality factors, the amplitudes decay with different time constants, wherein the processor 5 can be configured to fit a linear combination of several exponential functions having different time constants to the received signals, in order to separate the received resonator device signals and in order to determine from which resonator device which resonator device signals are received. The processor 5 knows the time constants of the different resonator devices and can use this information for determining which resonator device signals are received from which resonator devices. The locations of the several resonator devices on the patient 2 can be predetermined and already known to the processor 5. The processor 5 therefore preferentially knows at which location on the patient 2 which resonator device is arranged. This information can be input by a user like a physician via an input unit 6 which might be a keyboard, a computer mouse, a touchpad or any other input device. The locations of the resonator devices might also be determined automatically, for instance, based on an image like an MR image, a computed tomography image or another kind of image and a segmentation of the resonator devices in the image. Images might be shown to the user via a display 7.

As an alternative or in addition, as explained above, the resonator devices can have different resonance frequencies and these different resonance frequencies can be used by the processor 5 for determining which resonator device signals originate from which resonator device.

The eddy current distribution can be determined by measuring the resonator device signals under two conditions, i.e. under a first condition without the patient and under a second condition with the patient, wherein in both conditions the measurements are carried out in the same way. The differences between first resonator device signals, which have been measured under the first condition, and second resonator device signals, which have been measured under the second condition, then are due to eddy currents, wherein the processor 5 can be configured to carry out a simulation of the impact of different eddy current distributions on the resonator device signals. In particular, the processor 5 can modify the eddy current distribution used during the simulation such that the simulated impact on the first resonator device signals is similar to the measured difference between the first and second measured resonator device signals. For this simulation known physical relations between the respective eddy current distribution and its effect on the resonator device signals can be used. Moreover, known optimization algorithms, in particular known iterative optimization algorithms, can be used for finding the eddy current distribution which, during this simulation, leads to a simulated impact on the first resonator device signals that results in the measured second resonator device signals. The optimization algorithm can also use constraints like that the eddy current distribution can only have differences between eddy current values at neighboring spatial locations being smaller than a predefined threshold. Thus, a corresponding smoothness constraint can be used.

In an example, the magnet unit comprises one excitation coil and *N* receive coils, and *M* resonator devices are present. The excitation coil is used for simultaneously exciting the M resonator devices. The resonator devices are fully characterized, i.e. the resonator device field (frequency, amplitude, phase and damping constant), which they produce when excited with a known magnetic field, is known. Moreover, for both conditions, i.e. the first condition without the patient and the second condition with the patient, the positions and field profiles of the excitation coil and the *N* receive coils are known. Also the positions of the *M* resonator devices are known. In this example, *2MN* values are measured being the amplitudes and phases for each combination of a respective one of the *N* receive coils and a respective one of the M resonator devices. Also if the measurement is carried out under the second condition, *2MN* values are obtained. The *2MN* values measured under the first condition and the *2MN* values measured under the second condition differ from each other due to the eddy currents generated in the patient. The processor 5 can be configured to simulate the modification of the *2MN* values measured under the first condition by using several different eddy current distributions until the simulated modification corresponds to the difference between the *2MN* values measured under the first and second conditions.

In a further example, the processor 5 is configured to carry out the simulation based on different conductivity distributions, i.e. it is simulated how a respective conductivity distribution modifies the first resonator device signals, wherein the simulation is carried out for different conductivity distributions, until the simulation yields simulated second resonator device signals which are similar to the measured second resonator device signals. Also for this simulation known optimization algorithms, in particular known iterative optimization algorithms, can be used. Also a constraint can be used like that the difference in conductivity at two neighboring spatial locations within the respective conductivity distribution should not be larger than a predefined threshold. For the simulation, well-known physical relations between the conductivity distribution and the influence on resonator device signals can be used. The simulation can be a finite element method.

The processor 5 can be further configured to determine a magnetic induction tomography image and/or a pulse wave velocity in a pulmonary artery or the aorta of the patient 2 as the property based on the determined eddy current distribution. Thus, the processor 5 can be configured to use many resonator devices arranged on the patient 2 for deriving an eddy current distribution from the amplitude and phase effects on the received resonator device signals and to determine a magnetic induction tomography image based on the derived eddy current distribution. The processor 5 can be configured to use known reconstruction algorithms for determining the magnetic induction tomography image based on the eddy current distribution like the reconstruction algorithms disclosed in the above-mentioned article by H. Griffiths.

The determination of the eddy current distribution, conductivity distribution and/or magnetic induction tomography image can be carried out repeatedly with, for instance, a frequency of 1000 Hz. Due to the repeatedly determined eddy current distribution, conductivity distribution and/or magnetic induction tomography image, dynamic phenomena in the body can be monitored like the propagation of the pulse wave in the pulmonary arteries or the aorta, wherein this allows to determine the pulse wave velocity in the pulmonary artery or the aorta, respectively, by the processor 5. It is also possible to use a trained machine learning algorithm for monitoring dynamic phenomena like the pulse wave velocity in pulmonary arteries or the aorta directly based on the received resonator device signals. In particular, the machine learning algorithm can be trained by using training data sets, wherein the training data sets comprise resonator device signals which have been measured while the dynamic phenomenon to be monitored like the pulse wave velocity in a pulmonary artery was known. The machine learning algorithms is trained such that, given the respective measured resonator device signals, the respective known dynamic phenomenon like the respective known pulse wave velocity is output. Also in this case the machine learning algorithm can use a neural network like a convolutional network and/or a deep learning network.

The magnet unit 4 can be configured to excite the resonator device 8 by using a resonator device excitation pulse. If one or several resonator devices are used, which have a certain resonance frequency, in an example the resonator device excitation pulse can be centered on this certain resonance frequency. Moreover, in an example the magnet unit 4 can be configured to carry out the MRI imaging sequence for generating the MRI signals of the patient 2 in a predefined imaging frequency range of the MRI system 1 and to excite the one or several resonator devices 8 and to receive the resonator device signals from the one or several resonator devices 8 with a frequency which is within the imaging frequency range and which differs from the MR frequency of at least one of water and fat. Thus, the resonator device 8 can be tuned to a frequency in the imaging frequency range, wherein the magnet unit 4 can excite the resonator device 8 within this imaging frequency range. It therefore is possible to use the same frequency band for MRI and for determining the property of the patient based on the resonator device signals.

The resonator device signals preferentially are RF signals. Moreover, in an example the magnet unit 4 is configured to excite the resonator device 8 with an excitation pulse signal, which preferentially also is an RF signal, having a pulse duration being equal to or smaller than 20 µs. Generally, the pulse duration is preferentially such that the flip angle for protons is equal to or smaller than 1°. Furthermore, the magnet unit 4 can be configured to receive the resonator device signals and the MRI signals in parallel or in an interleaved way.

In an example, a resonator device can also be attached to at least one coil of the magnet unit 4. Such a resonator device 38 is indicated in Fig. 1 by the box 38. In Fig. 1, this resonator element 38 is only schematically indicated for clarity reasons. For instance, the resonator element 38 can be attached to a receive coil of the magnet unit 4.

Thus, the magnet unit 4 comprises coils configured to carry out the MRI sequence for generating the MRI signals of the patient 2, wherein to at least one of these coils a resonator device 38 is attached and wherein the processor 5 is configured to determine the position of the at least one coil over time. The processor 5 is further configured to determine motion of the at least one coil based on the determined position of the at least one coil over time and to generate a coil motion corrected MR image of the patient 2 based on the generated MRI signal and the determined motion of the at least one coil. For determining the motion of one coil, one or several resonator devices 38 might be attached to this one coil. For determining the motion of several coils of the magnet unit, to each of these coils at least one resonator device 38 might be attached. If several resonator devices are attached to a same coil, also a relative motion between different parts of the same coil can be monitored, i.e. a deformation of the coil can be monitored.

In an example, the processor 5 comprises sensitivity profiles of the coils of the magnet unit 4 and is configured to determine motion of the sensitivity profile of the at least one coil provided with the resonator device 38 based on the determined motion of the coil and to generate the coil motion corrected MR image of the patient 2 based on the generated MRI signal and the determined motion of the sensitivity profile. The processor 5 can be configured to use a known MR image reconstruction algorithm, which generally uses the position of the sensitivity profiles of the coils, which generally have been determined in pre-scans and which generally are not updated during an actual MRI procedure. Therefore, generally, a known MRI reconstruction algorithm produces image artifacts, if the coils move. Here, however, the known MRI reconstruction algorithm is used together with the current determined positions of the sensitivity profiles, thereby reducing or even eliminating image artifacts caused by coil motion. The known MRI reconstruction algorithm, which is used together with the determined current positions of the sensitivity profiles, is, for instance, the MRI reconstruction algorithm disclosed in the article "Augmented generalized SENSE reconstruction to correct for rigid body motion" by R. Bammer et al., Journal of Magnetic Resonance in Medicine, 57(1):90-102 (2007), which is herewith incorporated by reference. However, it is also possible to use another MRI reconstruction algorithm.

A resonator device can also be attached to an object not being the patient 2. For instance, as schematically and exemplarily illustrated in Fig. 3, a resonator device 28 can be attached to an interventional device 20 to be used during an interventional procedure. Correspondingly, the processor 5 can also be configured to determine a property of the object 20 like its position based on a resonator device signal received from the resonator device 28 attached to the object 20. In particular, if the object 20 is an interventional device for carrying out an interventional procedure on the patient 2, the processor 5 can be configured to determine the position of the resonator device 28 and to determine the position of the interventional device 20 based on the determined position of the resonator device 28. For instance, the processor 5 can be configured to determine the position over time, in order to track the interventional device 20 over time. It is thereby possible to track the interventional device 20 in the MRI system 1.

The magnet unit 4 preferentially is able to excite the several resonator devices 8, 28, 38, which might have different resonance frequencies and/or different quality factors, and to receive the resonator device signals from these resonator devices 8, 28, 38. These resonator device signals received from the resonator devices 8, 28, 38 have different frequencies and/or different attenuations due to the different quality factors, wherein the processor 5 can be configured to determine which resonator signals originate from which of the resonator devices 8, 28, 38 and to determine a respective property of the patient 2, of the at least one coil of the magnet unit 4 and of the interventional instrument 20 based on the several resonator device signals received by the magnet unit 4 from the respective resonator devices 8, 28, 38.

In an embodiment, only to the patient 2 and to the interventional device 20 resonator devices are attached, wherein the positions of the resonator devices attached to the patient 2 and the interventional device 20 are determined by the processor 5 and these positions are used for determining a property of the patient like patient motion and/or physiological parameters like the heart rate or the respiratory rate and for tracking the interventional device 20 within the MRI system 1.

It is also possible that many resonator devices are arranged on the patient 2, wherein these resonator devices have different resonance frequencies and/or different quality factors, in order to allow the processor 5 to determine the positions of the many resonator devices simultaneously over time, thereby defining a four-dimensional motion field. The processor 5 can then further be configured to directly use this four-dimensional motion field of the patient 2 for generating the motion corrected MR image. The processor 5 can also be configured to adapt a provided four-dimensional patient model to the four-dimensional motion field and to use the adapted four-dimensional patient model for generating the motion corrected MR image. For reconstructing the motion corrected MR image by using the determined four-dimensional motion field or the adapted four-dimensional patient model, known MR reconstruction algorithms can be used like the algorithm disclosed in the above mentioned article by R. Bammer et al., which is herewith incorporated by reference.

If the magnet unit 4 excites several resonator devices, the magnet unit 4 can be configured to excite the resonator devices with resonance frequencies within the predefined imaging frequency range, as explained above, wherein preferentially the magnet unit is configured to excite the resonator devices with reference frequencies on one side of the MR proton frequency, i.e. of the resonance frequency of hydrogen nuclei.

The resonator devices, which are described above, are preferentially passive and wireless. The coil element 10 preferentially is a loop coil and the resonator element 9 preferentially is a crystal resonator element like a quartz resonator element. The resonance frequency of the resonator element 9 and hence of the respective resonator device 8, 28, 38 comprising the resonator element 9 and the loop coil 10 can be, for instance, 64 MHz. The resonance frequency can also be different.

The resonator device 8, 28, 38 combines a magnetic coil resonator, in terms of the coil element 10, with an energy-storing oscillator, in terms of the resonator element 9 having piezoelectric properties. The magnet unit 4 of the MRI system 1 externally applies a magnetic or electromagnetic excitation field to cause mechanical oscillations at the resonance frequency of the resonator element 9. Hereby, the oscillation is persistent due to the high quality factor of the circuit.

In particular, as explained above, the respective resonator device 8, 28, 38 can be excited using a relatively short RF pulse of, for instance, 20 μs, which is picked up by its coil element 10, and starts a resonant mechanical oscillation in the resonator element 9 being, for example, a quartz crystal that stores energy. After excitation, the resonator element 9 feeds back its energy to the coil element 10, thereby generating the resonator device signal that might last several hundred microseconds and that is received by the magnet unit 4. Thus, once excited, the resonator device 8, 28, 38 can act as a local transmitter. Particularly due to the energy storage capability of the resonator device, the resonator device has a very high quality factor being equal to or larger than, for instance, 100. The quality factor can even be equal to or larger than 1,000 and even equal to or larger than 10,000.

The respective resonator device 8, 28, 38 also comprises a capacitance, wherein this capacitance can only be a stray capacitance or the resonator device also can comprise an explicit capacitive element for providing the capacitance like a capacitor. Generally, the resonator device comprises capacitive properties which can be present due to stray capacitance and/or an explicit capacitive element like a capacitor. The capacitive element may be added to the respective resonator device 8, 28, 38 such that it is connected in parallel to the coil element 10. That is, in a resonator device comprising a capacitive element, the coil element and the resonator element, the coil element and the resonator element might be connected in series and the capacitive element may be connected in parallel to the coil element. This essentially provides a resonator circuit which has an LC resonator and a piezoelectric resonator combined with one another.

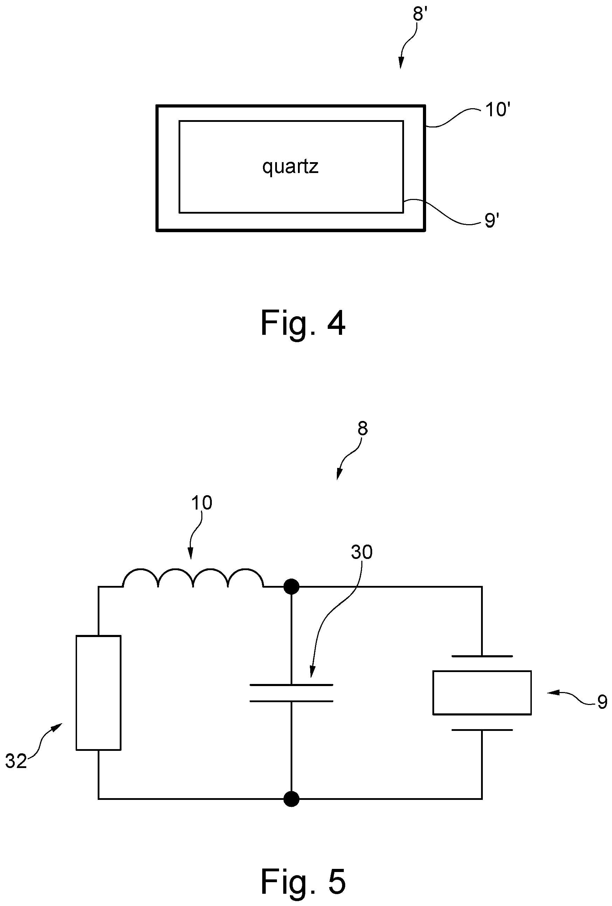

As schematically and exemplarily illustrated in Fig. 2, the coil element 10 might be printed on top and optionally also on the bottom of the resonator element 9. However, the coil element 10 can also be combined with the resonator element 9 in another way. For instance, as schematically and exemplarily illustrated in Fig. 4, the coil element 10' can be wound around the resonator element 9'. In Fig. 4, the resulting resonator device has the reference sign 8'.

Fig. 5 schematically and exemplarily shows an equivalent circuit for the resonator devices 8, 8' illustrated in Figs. 2 and 4. In Fig. 5, the circuit comprises the resonant element 9 and the coil element 10 which acts as a coil-based antenna, i.e. as an inductance. The equivalent circuit also has a resistance 32 and a capacitance 30, which are not explicitly realized in the examples illustrated in Figs. 2 and 4. However, as explained above, the capacitance can also explicitly be realized by adding a capacitive element like a capacitor. And, it is also possible to add a resistance explicitly to the resonator device.

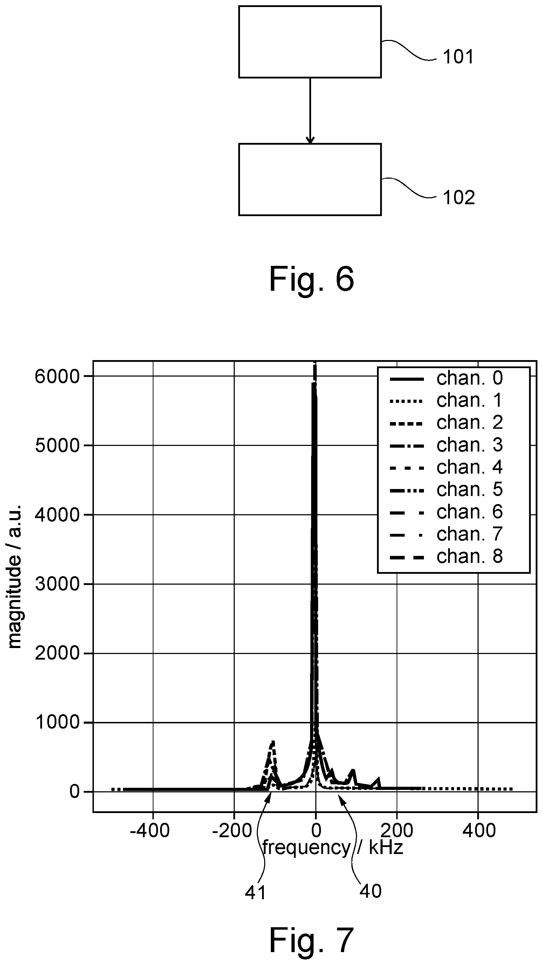

In the following, an example of an MRI method will exemplarily be described with reference to a flowchart shown in Fig. 6.

In step 101, an MRI sequence is carried out for generating MRI signals of the patient 2 by the magnet unit 4, wherein the magnet unit 4 further excites one or several of the resonator devices 8, 28, 38 which are attached to the patient 2, the interventional device 20 and the at least one coil of the magnet unit 4. Moreover, in step 101, the magnet unit receives resonator device signals from the excited one or more of the resonator devices 8, 28, 38.

In step 102, an MR image of the patient 2 is reconstructed based on the generated MRI signals and a property of the patient 2 or the interventional device 20 is determined based on the respective received resonator device signals by the processor 5. In particular, in step 102, a property of the patient 2 and/or a property of the interventional device 20 can be determined. Moreover, the motion of the at least one coil of the magnet unit 4 might be determined based on a determined motion of the resonator device 38 attached to the at least one coil, wherein this motion of the at least one coil can be used for reconstructing a corrected MR image by the processor 5. The determination of the property of the patient or the interventional device in step 102 can also be regarded as being a method for determining a property of a patient or an object in the MRI system 1.

The resonator devices described above can be used as wireless low-cost position markers that can be operated by the MRI system particularly concurrently with MR imaging without necessarily requiring hardware and/or MR imaging sequence modification.

In prior art systems, tracking of interventional devices usually relies on wired miniature coils tuned to a frequency of the MRI system and attached to the interventional devices. Since the miniature coils are wired coils, a wired connection is needed between the coils and a device that operates the coils. Correspondingly, connecting wires, which connect the coils of the interventional device to an operating system, need to be integrated into the interventional device that might be a guidewire, a catheter, a needle or another interventional device. This integration of the connecting wires into the interventional device requires a high technical effort and, if no further precautions are taken, poses a potential threat as wires heat up in the RF fields of the MRI system. These problems can be overcome by simply attaching one or several of the above described wireless passive resonator devices to the interventional device to be tracked.

Generally, MR imaging can be improved, if cardiac motion, respiratory motion or other patient motion is tracked and used for image reconstruction. Known techniques for tracking these different types of motion require additional effort of arranging a respiratory belt around the patient or connecting the patient to an electrocardiography (ECG) system. Also non-contact motion detection methods are known like camera systems or radar systems, but these systems require an additional infrastructure and, at least for the camera system, an unobstructed line of sight to a suitable surface of the patient. In contrast to this, by simply using one or several of the described resonator devices, which are passive and wireless, different types of motion can be tracked like cardiac motion, respiratory motion or another type of patient motion. Just the one or more resonator devices are necessarily required and not a technically complicated additional motion tracking system.

The tracking solution provided by using the one or several resonator devices uses, as described above, the resonance of an LC circuit that is coupled to the resonator element like a quartz crystal for energy storage, which also leads to a high quality factor. This coupled design, i.e. the LC circuit coupled to the resonator element, allows, for instance, to track the patient or an interventional device using hardware with rather slow transmit/receive switching times and thus is suitable for MRI systems. In particular, a clinical MRI system can be used to excite and read, i.e. receive, the resonator device signals, without necessarily requiring hardware modification and without interfering with the MR imaging process. Small software modifications on the processor suffice to add the tracking functionality or the determination of another property of the patient or the interventional device to the MRI system.

Due to the combination of the energy-storing resonator element and the coil element, the resonance peaks of the resonator devices can be relatively narrow, wherein for this reason many of these resonator devices can be operated in parallel and then be resolved spectrally, if these resonator devices are tuned to different resonance frequencies. As described above, it is also possible to distinguish between different resonator devices, if these resonator devices have a same or a similar resonance frequency, but different quality factors and hence different attenuations. The resonator devices can be used as markers for determining positions with 5 degrees of freedom or for other purposes like as pilot tone sources controlled by the RF fields of the MRI system. As also explained above, the resonator devices can also be used for monitoring patient motion, breathing, cardiac related parameters like the pulse, for tracking interventional devices and for dynamically localizing receive coil positions for improved sensitivity-encoded reconstruction accuracy.

Fig. 7 schematically and exemplarily illustrates a single readout of nine receive coils of the magnet unit 4 during a simultaneous MR imaging and property determination procedure carried out by using a resonator device. In particular, Fig. 7 shows the magnitude of the respective signal in arbitrary units depending on the frequency. In this figure, the frequency dimension has been shifted such that the resonance frequency of the resonator device is at the zero position. Thus, the horizontal axis does not show the actual frequency, but the difference to the resonance frequency of the resonator device. Fig. 7 shows at the position 40 the resonance of the resonator device and at the position 41 the resonance of protons, i.e. of hydrogen nuclei. Thus, Fig. 7 illustrates an example in which an excitation pulse excites both, the protons and the resonator device such that the shown spectra comprise two resonance peaks.

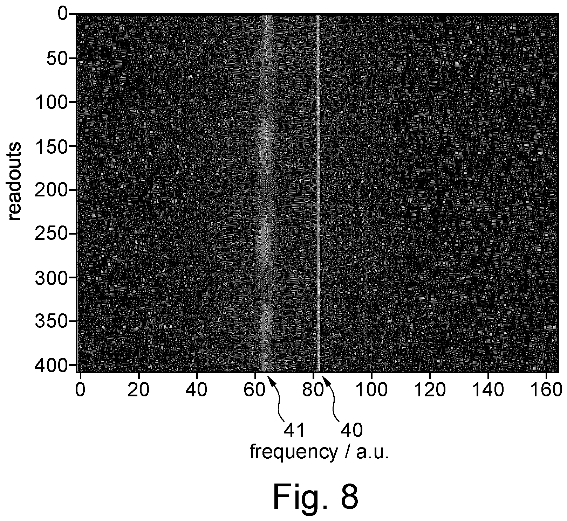

Fig. 8 schematically and exemplary illustrates the signals received by a single receive coil of the magnet unit 4 over time during an MRI sequence. The vertical axis shows the number of the respective readout and the horizontal axis shows the frequency in arbitrary units. The grey level in this two-dimensional diagram indicates the magnitude. In this example encoding field gradients are generated by the gradient coils of the magnet unit 4 for providing the spatial encoding for the MR imaging. These field gradients lead to a broadening of the proton resonance at the position 41 into a position-dependent sinogram, wherein the resonance of the resonator device at the position 40 is not affected by the field gradients. The resonance of the resonator device is only determined by the frequency of the resonator element being, in this example, a quartz crystal, i.e. in this example, the resonance frequency of the resonator device is the quartz frequency. Since the resonance frequency of the resonator device is not affected by the field gradients, in the spectral plot shown in Fig. 8 the resonator device is indicated by the straight line. Fig. 8 was generated by using a radial MRI scan with an ultrashort echo time of 140 $\mu$s. However, also if MRI and property determination based on the resonator device are carried out by using another MRI sequence, the resonator device is very well visible in a spectral plot as shown in Fig. 8.

In an example, in particular in the example illustrated in Figs. 7 and 8, the resonance frequency of the resonator device is chosen to lie outside the frequency range of the proton signals. Excitation pulses for exciting the resonator device can be interleaved with MRI sequence pulses, wherein the respective excitation pulse for exciting the resonator device preferentially is centered on the resonance frequency of the resonator device. Moreover, preferentially the excitation pulse for exciting the resonator device is configured such that it does not excite protons. This excitation pulse hence is spectrally selective such that it excites the resonator device but not the protons. It is hereby noted that this excitation pulse preferentially also is relatively short, i.e. has a length of, for instance, 20 $\mu$s, such that, even if the excitation pulse excited protons, the possibly resulting effect on MR imaging would be rather low, because of the small flip angle applied. The interference of the resonator device excitation pulse, which preferentially is an RF pulse, with the protons therefore would be minimal.

As can also be seen in Figs. 7 and 8, there is enough bandwidth to resolve several resonator devices that are tuned to different frequencies in the receive band of the receive coils of the magnet unit 4. For instance, the magnet unit 4 can be configured to excite all resonator devices with frequencies on one side of the proton resonance 41 jointly particularly by using relatively short excitation pulses or they could be excited selectively particularly by using relatively long excitation pulses.

Once excited, the one or several resonator devices act as local transmitters, wherein, depending on the placement of the one or several resonator devices, they could be seen as "pilot tone" transmitters of known position and strength, wherein the resonator device signals of these resonator devices are picked up by the receive coils of the magnet unit 4, wherein the amplitude and the phase of these picked up resonator device signals is modulated by the patient body. The processor can use this modulation of the amplitude and the phase by the patient body to extract information on patient anatomy, positioning and motion as described above. In comparison to the pilot tone transmitters disclosed in US 10,393,845 B2, by using the resonator devices as described above, information about patient anatomy, positioning and motion can be determined with reduced technical efforts.

The one or several resonator devices can be placed on the patient or an object like the interventional device for tracking the same, wherein the position of the resonator devices and hence of the patient and/or the object overtime can be determined, for instance, by pure sensitivity encoding based on the amplitude distribution observed in a fixed coil array with known coil sensitivity profiles, i.e. based on the amplitudes of the resonator device signals received by the receive coils of the magnet unit. The one or several resonator devices can be placed, for instance, directly on the patient like on the skin of the chest to detect breathing and heartbeat, on the head to track involuntary motion in brain scans, or in a further example the one or several resonator devices can be placed on one or several receive coils, which might be placed on the patient, to track the motion of the one or several receive coils and update the information used in sensitivity-encoded image reconstruction.

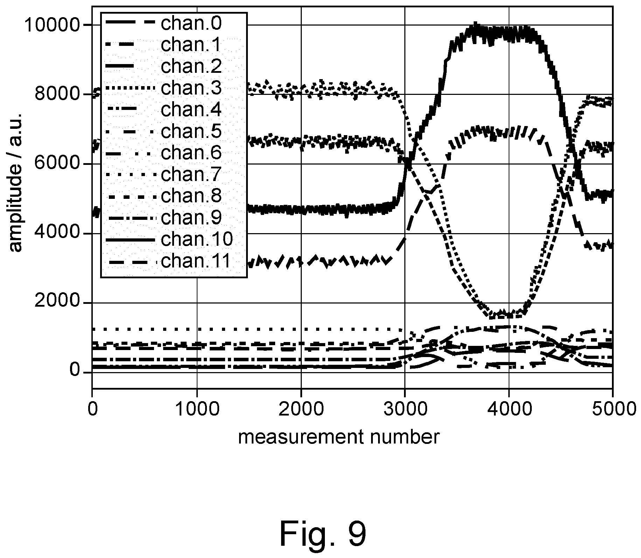

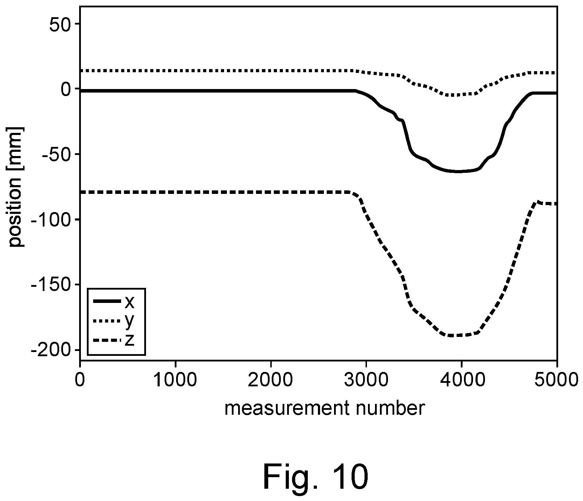

Fig. 9 exemplarily illustrates how resonator device signals of a single resonator device received by twelve receive coils of the magnet unit change, if the resonator device moves within the MRI system 1. Fig. 9 shows the amplitude of the respective resonator device signal received by the respective receive coil for several consecutive measurements and hence over time. The corresponding changes of the position of the resonator device, which is determined by the processor 5 based on the resonator device signals that are received by the receive coils and shown in Fig. 9, is illustrated in Fig. 10. Fig. 10 shows the position in mm depending on the respective measurement and hence depending on time. In this example, the positional noise is smaller than 100 $\mu$m. The receive coils are fixed, i.e. they are not, for instance, arranged on the patient's chest. The processor 5 determines the position based on the prior knowledge about the spatial sensitivity profiles of the fixed array of the twelve receive coils used for receiving the resonator device signals.

Several resonator devices can be operated in parallel and their signals can be spectrally resolved, thereby enabling expanding, for instance, a simple tracking concept to a determination of a four-dimensional field of motion vectors, to which, for example, a patient model can be fitted to increase the accuracy of motion tracking with respect to a patient. The motion information can then be fed back into MR image reconstruction to remove motion artifacts, as described above. Extending the pilot tone concept towards many transmitters allows for a derivation of eddy current distributions from the amplitude and phase effect on the detected resonator device signals, finally giving the information used for magnetic induction tomography as also described above. Based on this information, the processor can extract, for instance, pulse wave velocities in pulmonary arteries or the aorta.

The one or several resonator devices can be used, for instance, for simple device tracking in MRI, for coil tracking for improved sensitivity-encoded MRI reconstruction, for coil deformation tracking for improved sensitivity-encoded MRI reconstruction, for patient breathing monitoring, heartbeat monitoring and motion detection for motion compensation in MRI imaging, for conventional pilot tone applications, i.e. detection of coil loading, amplitudes, phases, thereby delivering additional information on patient position and motion including breathing and heartbeat, et cetera.

Although in above described embodiments the processor is a part of the MRI system, the processor can also be a separate device which might be located in the same room as the magnet unit of the MRI system or in another room. The processor can be located everywhere and it can even be a cloud computer, as long as it can receive the resonator device signals and the MRI signals from the magnet unit.

The processor can comprise subprocessors, wherein at least one subprocessor can be configured to determine the property of the patient and/or the object based on the resonator device signals. The subprocessors can be integrated or separate subprocessors. For instance, a subprocessor for reconstructing the MR image can be located in the same room as the magnet unit or in a neighboring room, or at least in a room within the same building, whereas the subprocessor, which determines the property of the patient and/or the object based on the resonator device signals, can be everywhere and particularly a cloud computer, as long as it can receive the resonator device signals from the magnet unit.

Other variations to the disclosed embodiments can be understood and effected by those skilled in the art in practicing the claimed invention, from a study of the drawings, the disclosure, and the appended claims.

In the claims, the word "comprising" does not exclude other elements or steps, and the indefinite article "a" or "an" does not exclude a plurality.

A single unit or device may fulfill the functions of several items recited in the claims. The mere fact that certain measures are recited in mutually different dependent claims does not indicate that a combination of these measures cannot be used to advantage.

Calculations like the determination of a property of a patient and/or an object not being the patient, reconstructing an MR image, et cetera performed by one or several units or devices can be performed by any other number of units or devices. The calculations and/or the control of the MRI system in accordance with the MRI method and/or the control of the processor in accordance with the method for determining a property of a patient and/or an object can be implemented as program code means of a computer and/or as dedicated hardware.

A computer program may be stored/distributed on a suitable medium, such as an optical storage medium or a solid-state medium, supplied together with or as part of other hardware, but may also be distributed in other forms, such as via the Internet or other wired or wireless telecommunication systems.

Any reference signs in the claims should not be construed as limiting the scope.

The invention relates to an MRI system comprising a magnet unit that carries out an MRI sequence for generating MRI signals of a patient, excites a resonator device attached to the patient or to an object not being the patient and comprising a resonator element having piezoelectric properties and a coil element connected to the resonator element, and receives resonator device signals from the resonator device. A processor reconstructs an MR image of the patient based on the MRI signals and determines a property of the patient or the object, to which the resonator device is attached, based on the received resonator device signals. This allows determining the property of the patient or the object by the MRI system without necessarily requiring, besides the resonator device, additional hardware, i.e. the property can be determined without requiring sophisticated additional hardware.

**Claims**

1. A magnetic resonance imaging system (1) comprising:

- a magnet unit (4) configured to carry out a magnetic resonance imaging sequence for generating magnetic resonance imaging signals of a patient (2), wherein the magnet unit (4) is further configured to excite a resonator device (8, 28, 38), which is attached to the patient (2) or to an object (20) not being the patient (2) and which comprises a resonator element (9) having piezoelectric properties and a coil element (10) connected to the resonator element (9), and to receive resonator device signals from the resonator device (8, 28, 38), and
- a processor (5) that is configured to reconstruct a magnetic resonance image of the patient (2) based on the magnetic resonance imaging signals and to determine a property of the patient (2) or the object (20), to which the resonator device (8, 28, 38) is attached, based on the received resonator device signals.

2. The magnetic resonance imaging system of claim 1, wherein the processor (5) is configured to determine the position of the resonator device (8, 28, 38) based on the received resonator device signals and to determine, as the property of the patient (2) or the object (20), to which the resonator device (8, 28, 38) is attached, the position of the patient (2) or the object (20), respectively, based on the determined position of the resonator device (8, 28, 38).

3. The magnetic resonance imaging system (1) of claim 2, wherein the resonator device (8) is attached to the patient (2), wherein the processor (5) is configured to determine the position of the patient (2) over time, to determine patient motion based on the determined position of the patient (2) over time, and to reconstruct a motion corrected magnetic resonance image of the patient (2) based on the generated magnetic resonance imaging signal and the determined patient motion and in particular to determine a patient motion related physiological parameter based on the determined patient motion.

4. The magnetic resonance imaging system (1) of claims 2 to 3, wherein the magnet unit (4) comprises coils configured to carry out the magnetic resonance imaging sequence for generating the magnetic resonance imaging signals of the patient (2), wherein at least one coil is regarded as being the object (20) to which the resonator device (38) is attached and wherein the processor (5) is configured to determine the position of the at least one coil over time, to determine motion of the at least one coil based on the determined position of the at least one coil over time and to generate a coil motion corrected magnetic resonance image of the patient (2) based on the generated magnetic resonance imaging signal and the determined motion of the at least one coil.

5. The magnetic resonance imaging system (1) of any of the preceding claims, wherein the magnet unit (4) is able to excite several resonator devices (8, 28, 38), which have different resonance frequencies and/or different quality factors and which are attached to at least one of the patient (2) and the object (20), and to receive several resonator device signals, which have different frequencies that correspond to the different resonance frequencies of the several resonator devices (8, 28, 38) and/or different attenuations corresponding to the different quality factors of the several resonator devices (8, 28, 38), from the several resonator devices (8, 28, 38), wherein the processor (5) is configured to determine one or several properties of at least one of the patient (2) and the object (20), to which the respective resonator device (8, 28, 38) is attached, based on the received resonator device signals.

6. The magnetic resonance imaging system (1) as defined by any of the preceding claims, wherein the processor (5) is configured to a) determine at least one of the amplitude and the phase of the received resonator device signals, b) determine a modulation of at least one of the amplitude and the phase by at least one of the patient (2) and the object (20), and c) carry out at least one of i) determining modulation-corrected received resonator device signals based on the determined modulation and a received resonator device signals and determining the property based on the modulation-corrected received resonator device signals and ii) determining the property directly based on the determined modulation.

7. The magnetic resonance imaging system (1) as defined by any of the preceding claims, wherein the magnet unit (4) is configured to excite several resonator devices (8), which are arranged at different locations on the patient (2) and which have different resonance frequencies and/or different quality factors, and to receive several resonator device signals, which have different frequencies that correspond to the different resonance frequencies of the several resonator devices (8) and/or which have different attenuations that correspond to the different quality factors, from the several resonator devices (8), wherein the processor (5) is configured to determine which resonator device signals originate from which location on the patient (2) based on the different frequencies and/or the different attenuations, to determine an eddy current distribution within the patient (2) based on the received resonator device signals and based on the locations from which the received resonator device signals originate and to determine the property of the patient (2) based on the determined eddy current distribution.

8. The magnetic resonance imaging system (1) as defined by claim 7, wherein the processor (5) is configured to determine at least one of a magnetic induction tomography image and a pulse wave velocity in a pulmonary artery or the aorta of the patient (2) as the property based on the determined eddy current distribution.

9. The magnetic resonance imaging system (1) of any of the preceding claims, wherein the magnet unit (4) is configured to carry out the magnetic resonance imaging sequence for generating the magnetic resonance imaging signals of the patient (2) in a predefined imaging frequency range of the magnetic resonance imaging system (1) and to excite the resonator device (8, 28, 38) and to receive the resonator device signals from the resonator device (8, 28, 38) with a frequency which is within the imaging frequency range.

10. A processor for determining a property of a patient (2) or an object (20) in the magnetic resonance imaging system of any of claims 1 to 9, wherein a resonator device (8, 28, 38) is attached to the patient or the object, wherein the processor (5) is configured to determine the property based on received resonator device signals, wherein the resonator device signals have been received from the resonator device (8, 28, 38) by a magnet unit (4) of the magnetic resonance imaging system (1), after the magnet unit (4) has excited the resonator device (8, 28, 38), wherein the resonator device (8, 28, 38) comprises a resonator element (9) having piezoelectric properties and a coil element (10) connected to the resonator element (9).

11. A resonator device configured for allowing a processor (5) as defined by claim 10 to determine a property of a patient (2) or an object (20) in a magnetic resonance imaging system as defined by any of claims 1 to 11, when the resonator device (8, 28, 38) is attached to the patient (2) or the object (20), respectively, wherein the resonator device (8, 28, 38) comprises a resonator element (9) having piezoelectric properties and a coil element (10) connected to the resonator element (9) and is configured to generate resonator device signals when the resonator device (8, 28, 38) is excited by a magnet unit (4) of the magnetic resonance imaging system (1).

12. A magnetic resonance imaging method comprising:

- carrying out a magnetic resonance imaging sequence for generating magnetic resonance imaging signals of a patient (2) by a magnet unit (4), wherein the magnet unit (4) further excites a resonator device (8, 28, 38), which is attached to the patient (2) or to an object (20) not being the patient (2) and which comprises a resonator element (9) having piezoelectric properties and a coil element (10) connected to the resonator element (9), and receives resonator device signals from the resonator device (8, 28, 38), and
- reconstructing a magnetic resonance image of the patient (2) based on the magnetic resonance imaging signals and determining a property of the patient (2) or the object (20), to which the resonator device (8, 28, 38) is attached, based on the received resonator device signals by a processor (5).

13. A method for determining a property of a patient (2) or an object (20) in the magnetic resonance imaging system of any of claims 1 to 11, wherein a resonator device (8, 28, 38) is attached to the patient or the object, the method comprising determining the property based on received resonator device signals, wherein the resonator device signals have been received from the resonator device (8, 28, 38) by a magnet unit of the magnetic resonance imaging system, after the magnet unit has excited the resonator device, wherein the resonator device comprises a resonator element (9) having piezoelectric properties and a coil element (10) connected to the resonator element (9).

14. A computer program for controlling a magnetic resonance imaging system as defined by any of claims 1 to 9, the computer program comprising program code means for causing the magnetic resonance imaging system to carry out the steps of the magnetic resonance imaging method as defined by claim 12, when the computer program is run on a computer controlling the magnetic resonance imaging system.

15. A computer program for determining a property of a patient (2) or an object (20) in the magnetic resonance imaging system of any of claims 1 to 9, wherein a resonator device (8, 28, 38) is attached to the patient or the object, wherein the computer program is configured to, when the computer program is run on a computer, determine the property based on received resonator device signals, wherein the resonator device signals have been received from the resonator device (8, 28, 38) by a magnet unit of the magnetic resonance imaging system, after the magnet unit has excited the resonator device, wherein the resonator device comprises a resonator element (9) having piezoelectric properties and a coil element (10) connected to the resonator element (9).

Fig. 1

8

10

quartz

9

# Fig. 2

20

28

# Fig. 3

8'

10'

quartz

9'

# Fig. 4

8

10

30

32

9

# Fig. 5

Fig. 6

Fig. 7

41  40
frequency / a.u.

Fig. 8

Fig. 9

Fig. 10

Europäisches
Patentamt

European
Patent Office

Office européen
des brevets

# EUROPEAN SEARCH REPORT

Application Number

EP 22 21 2192

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | YARAS Y. S. ET AL.: "Acousto-optic Based Active MRI Marker for Interventional MRI Devices", PROCEEDINGS OF THE INTERNATIONAL SOCIETY FOR MAGNETIC RESONANCE IN MEDICINE, 25TH ANNUAL MEETING, no. 14, 7 April 2017 (2017-04-07), XP040687582, Honolulu, HI, USA * the whole document * | 1,2,9-15 | INV. G01R33/28 G01R33/341 G01R33/565 G01R33/563 ADD. G01R33/44 G01R33/3415 |
| X | EP 4 014 856 A1 (KONINKLIJKE PHILIPS NV [NL]) 22 June 2022 (2022-06-22) * the whole document * | 11 | |
| X | YARAS YUSUF SAMET ET AL: "Acousto-Optic Catheter Tracking Sensor for Interventional MRI Procedures", IEEE TRANSACTIONS ON BIOMEDICAL ENGINEERING, IEEE, USA, vol. 66, no. 4, April 2019 (2019-04), pages 1148-1154, XP011715466, ISSN: 0018-9294, DOI: 10.1109/TBME.2018.2868830 [retrieved on 2019-03-19] | 1,2,5, 9-15 | |
| A | * the whole document * | 3,4,6-8 | |
| X | US 2014/171784 A1 (OOI MELVYN B [US] ET AL) 19 June 2014 (2014-06-19) * claims 1,5,6 * | 1-4,9 | |

TECHNICAL FIELDS SEARCHED (IPC)

G01R

-/--

The present search report has been drawn up for all claims

| Place of search | Date of completion of the search | Examiner |
|---|---|---|
| Munich | 26 April 2023 | Skalla, Jörg |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

.............................................................

& : member of the same patent family, corresponding document

EPO FORM 1503 03.82 (P04C01)

Europäisches
Patentamt

European
Patent Office

Office européen
des brevets

# EUROPEAN SEARCH REPORT

Application Number

EP 22 21 2192

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | SCHILDKNECHT C.M. ET AL.: "Wireless motion tracking with short-wave radiofrequency", PROCEEDINGS OF THE INTERNATIONAL SOCIETY FOR MAGNETIC RESONANCE IN MEDICINE, 27TH ANNUAL MEETING & EXHIBITION, no. 66, 26 April 2019 (2019-04-26), XP040707453, Montréal, QC, Canada * the whole document * ----- | 1-4,6 | |

**TECHNICAL FIELDS SEARCHED (IPC)**

The present search report has been drawn up for all claims

| Place of search | Date of completion of the search | Examiner |
|---|---|---|
| Munich | 26 April 2023 | Skalla, Jörg |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons
.....................................................................................
& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 22 21 2192

This annex lists the patent family members relating to the patent documents cited in the above-mentioned European search report.
The members are as contained in the European Patent Office EDP file on
The European Patent Office is in no way liable for these particulars which are merely given for the purpose of information.

26-04-2023

| Patent document cited in search report | | Publication date | Patent family member(s) | | Publication date |
|---|---|---|---|---|---|
| EP 4014856 | A1 | 22-06-2022 | EP | 4014856 A1 | 22-06-2022 |
| | | | WO | 2022129310 A1 | 23-06-2022 |
| US 2014171784 | A1 | 19-06-2014 | NONE | | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 10393845 B2
- WO 2022129310 A1
- US 5752513 A

**Non-patent literature cited in the description**

- **S. KOS et al.** MR-guided endovascular interventions: a comprehensive review on techniques and applications. *European Radiology,* 2008, vol. 18 (4), 645-657
- **H. GRIFFITHS.** Magnetic induction tomography. *Measurement Science and Technology,* 2001, vol. 12 (8), 1126-1131
- **F. GODENSCHWEGER et al.** Motion correction in MRI of the brain. *Journal of Physics in Medicine and Biology,* 2016, vol. R61 (5), R32-56
- **R. BAMMER et al.** Augmented generalized SENSE reconstruction to correct for rigid body motion. *Journal of Magnetic Resonance in Medicine,* 2007, vol. 57 (1), 90-102